# EUROPEAN PATENT SPECIFICATION

(11) **EP 3 903 892 B1**
(45) Date of publication and mention of the grant of the patent: **11.02.2026**
(21) Application number: 20171682.6
(22) Date of filing: 28.04.2020
(51) Int. Cl.: A62C 3/16, A62C 35/13, A62C 37/38, F16K 17/04, H01F 27/40, H05K 7/20

(54) **ELECTRIC APPARATUS COMPRISING PRESSURE RELIEF DEVICE**
ELEKTRISCHE VORRICHTUNG MIT DRUCKENTLASTUNGSVORRICHTUNG
APPAREIL ÉLECTRIQUE COMPRENANT UN DISPOSITIF DE DÉTENTE DE PRESSION

(43) Date of publication of application: 03.11.2021
(73) Proprietor: ABB Schweiz AG, 5400 Baden (CH)
(72) Inventor: Salmia, Teemu, 00380 Helsinki (FI); Hartikainen, Pyry, 00380 Helsinki (FI); Niiranen, Simo Oskari, 00380 Helsinki (FI)
(74) Representative: Kolster Oy Ab

(56) References cited:
- WO-A1-2016/134458
- CN-U- 201 783 112

## Description

### FIELD OF THE INVENTION

The present invention relates to an electrical apparatus comprising a pressure relief device.

A known electric apparatus comprises a housing, an electric equipment located inside the housing, a fluid port providing a fluid connection from inside of the housing to outside of the housing, and a pressure relief device having a first operating position adapted to prevent fluid flow through the fluid port, and a second operating position adapted to allow fluid flow through the fluid port.

In a fault situation in which an electric arc occurs in the electric equipment inside the housing, air surrounding the electric arc expands thereby raising a pressure inside the housing. Said pressure rise inside the housing transfers the pressure relief device from the first operating position to the second operating position, thereby allowing hot gases to flow out of the housing.

One such electric apparatus is disclosed in CN 201 783 112 U, which discloses an oil-filled housing. In WO 2016/134458 A1, such a housing filled with gas is disclosed.

One of the problems associated with the above known electric apparatus is that the hot gases flowing out of the housing through the fluid port can include combustible gases which are not on fire inside the housing but which might catch fire outside the housing when their concentration decreases. Further, it is also possible that the hot gases catch fire inside the housing, wherein flames erupt from the fluid port. Therefore, the hot gases flowing out of the housing cause fire hazard in the vicinity of the fluid port.

### BRIEF DESCRIPTION OF THE INVENTION

An object of the present invention is to provide an electric apparatus so as to solve the above problem. The objects of the invention are achieved by an electric apparatus which is characterized by what is stated in the independent claim. The preferred embodiments of the invention are disclosed in the dependent claims.

The invention is based on the idea of providing an electric apparatus with a fire prevention system comprising fire prevention substance, wherein the fire prevention system is adapted to release the fire prevention substance when a fault situation relating to the electric equipment located inside the housing is detected. In an embodiment, the fault situation is simply detected based on a transition of the pressure relief device from the first operating position to the second operating position, and said transition triggers the release of the fire prevention substance.

An advantage of the electric apparatus of present invention is that a fire hazard caused by a fault situation can be minimized or even eliminated.

### BRIEF DESCRIPTION OF THE DRAWINGS

In the following the invention will be described in greater detail by means of preferred embodiments with reference to the attached drawings, in which
Figure 1 shows an electric apparatus according to an embodiment of present invention;
Figure 2 shows a cross section of the electric apparatus of Figure 1;
Figure 3 shows an enlargement of portion A of the cross section of Fig-ure 2; and
Figure 4 shows a pressure relief device and fire prevention system of the electric apparatus of Figure 1.

### DETAILED DESCRIPTION OF THE INVENTION

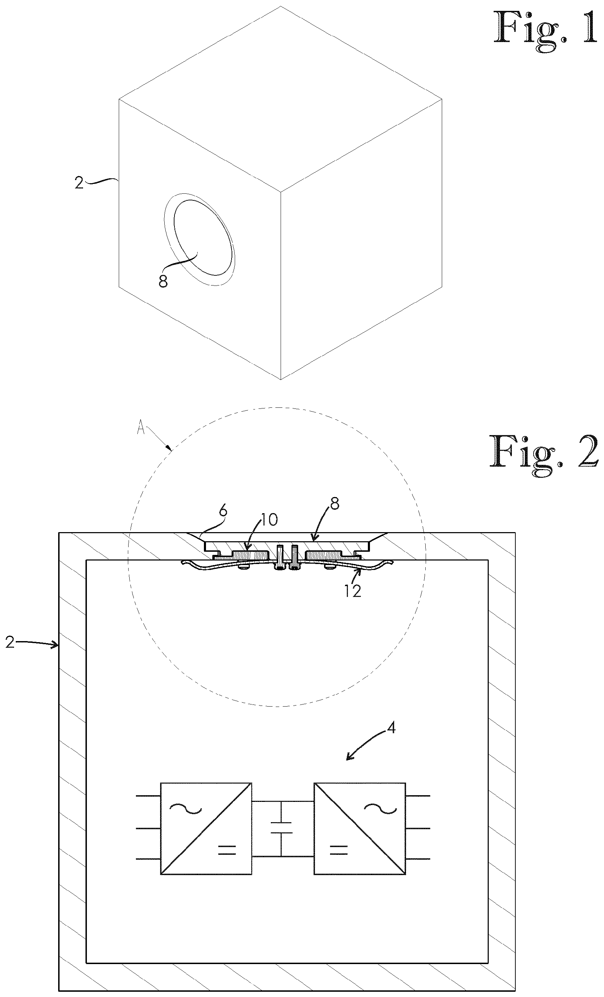

Figure 1 shows an electric apparatus according to an embodiment of the invention, and Figure 2 shows a cross section of the electric apparatus. The electric apparatus comprises a housing 2, an electric equipment 4, a fluid port 6, a pressure relief device 8, a fire prevention system 10, and a detection system adapted to detect a fault situation relating to the electric equipment 4 based on at least one indicative event.

The electric equipment 4, which is depicted schematically in Figure 2, is located inside the housing 2, and comprises an electric converter adapted to convert electric energy from one form to another. The electric converter is a frequency converter. In an alternative embodiment, the electric converter is an inverter or some other converter comprising a plurality of controllable semiconductor switches.

The housing 2 contains air such that the electric equipment 4 is partially surrounded by the air. In an alternative embodiment, the housing contains gas other than air, and the electric equipment is at least partially surrounded by the gas.

The fluid port 6 provides a fluid connection from inside of the housing 2 to outside of the housing 2. The fluid port 6 comprises an aperture in a wall of the housing 2.

The pressure relief device 8 has a first operating position adapted to prevent fluid flow through the fluid port 6, and a second operating position adapted to allow fluid flow through the fluid port 6. In Figure 2 the pressure relief device 8 is in the first operating position. A transition of the pressure relief device 8 from the first operating position to the second operating position is adapted to take place as a response to a first predetermined pressure rise inside the housing 2. In other words, the first predetermined pressure rise inside the housing 2 moves the pressure relief device 8 outwards relative to the housing 2.

Referring to Figures 1 and 2, the pressure relief device 8 defines a pressure relief device plane, and the fluid port 6 is provided on a planar section of the housing 2 defining a first housing plane, wherein during the transition of the pressure relief device 8 from the first operating position to the second operating position, the pressure relief device plane remains parallel to the first housing plane while the pressure relief device 8 moves outwards relative to the housing 2. In an alternative embodiment, the pressure relief device comprises a pressure relief valve and/or pressure relief flap hinged to the housing from one of its edges.

The fire prevention system 10 comprises fire prevention substance, and is operatively connected to the detection system. The fire prevention system 10 is adapted to release the fire prevention substance inside the housing 2 as a response to the fault situation detected by the detection system.

Herein, releasing the fire prevention substance means releasing at least a portion of a total amount of fire prevention substance in the fire prevention system. In some embodiments, release of the fire prevention substance is stopped as a response to a transition of the pressure relief device from the second operating position back to the first operating position.

In an embodiment, the fire prevention substance comprises carbon dioxide or other substance adapted to displace oxygen. In another embodiment, the fire prevention substance comprises liquid nitrogen or other substance adapted to lower temperature. In yet another embodiment, the fire prevention substance comprises dry water or other substance adapted to trap explosive gases. The dry water, which is sometimes referred to as empty water, is a water-air emulsion in which tiny water droplets are surrounded by a sandy silica coating.

The at least one indicative event comprises the transition of the pressure relief device 8 from the first operating position to the second operating position. Said transition is a usable indication since it is caused by the first predetermined pressure rise inside the housing 2 which in its turn is a strong indication of an electric arc in the electric equipment 4 inside the housing 2. Said transition causes the fire prevention system 10 to release the fire prevention substance inside the housing 2.

The first predetermined pressure rise inside the housing 2 causes the transition of the pressure relief device 8 from the first operating position to the second operating position because the excess pressure generates a force acting upon the pressure relief device 8 in an outwards direction. Further, the first predetermined pressure rise inside the housing 2 inherently creates a fluid flow from inside of the housing 2 to outside of the housing 2 through the fluid port 6. The fluid flow carries the fire prevention substance out of the housing.

The first predetermined pressure rise inside the housing 2 is selected such that it is greater than any pressure rise occurring inside the housing 2 during transportation, installation and normal use of the electric apparatus. In an embodiment, the first predetermined pressure rise inside the housing is defined by difference between pressure inside the housing and outside the housing. In another embodiment, criteria for presence of the first predetermined pressure rise inside the housing include conditions for rate of rise for the pressure inside the housing.

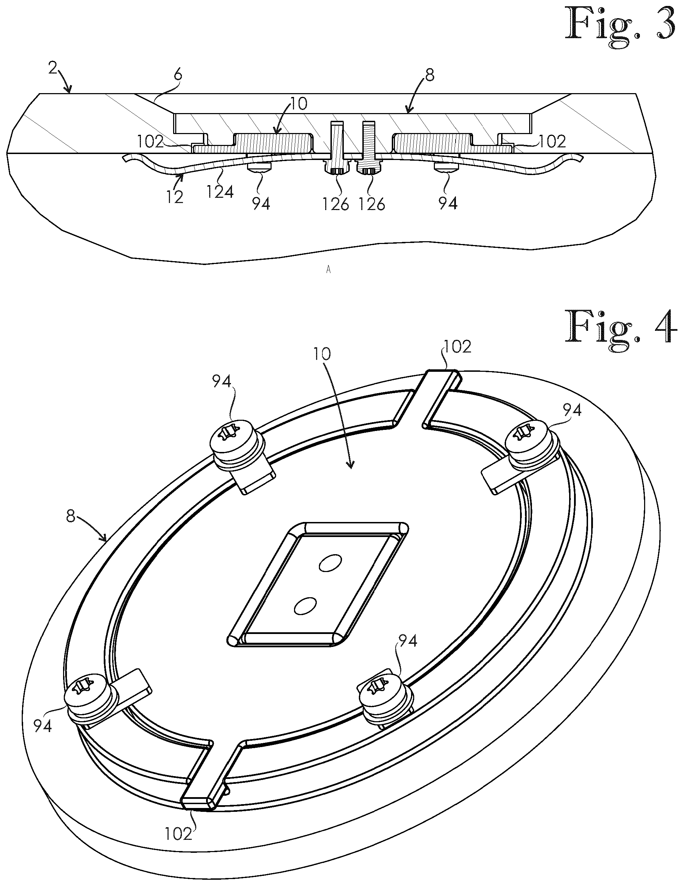

Referring to Figure 3, the pressure relief device 8 is supported to the housing 2 by a support structure 12 comprising a plate spring 124 fastened to the pressure relief device 8 by screws 126. The plate spring 124 is in contact with an inner surface of the housing 2, and is adapted to return the pressure relief device 8 to the first operating position if the pressure relief device 8 is deflected therefrom in the direction of the second operating position.

The fire prevention system 10 comprises a disposable cartridge containing the fire prevention substance. The disposable structure is used because in practise, an electric arc occurring in a frequency converter destroys the frequency converter. In an alternative embodiment, the fire prevention system comprises a reusable container provided with a valve operationally connected to the detection system. The valve is adapted to release a necessary amount of fire prevention substance, and to leave the rest of the fire prevention substance in the reusable container for later use. In another alternative embodiment, the fire prevention system comprises a plurality of disposable cartridges comprising different fire prevention substances.

Figure 4 shows the pressure relief device 8 and the fire prevention system 10 fastened to the pressure relief device 8. The screws 126 and the plate spring 124 have been detached from the pressure relief device 8.

Referring to Figure 4, the fire prevention system 10 is fastened to the pressure relief device 8 by a fastening system comprising four fastening screws 94. By screwing out the four fastening screws 94, it is possible to detach the fire prevention system 10 from the pressure relief device 8.

The detection system comprises two detection protrusions 102 attached to the fire prevention system 10. During a transition of the pressure relief device 8 from the first operating position to the second operating position, the detection protrusions 102 are adapted to be in contact with an edge of the fluid port 6 such that the detection protrusions 102 bend. The detection system is adapted to detect the fault situation based on the bending of the detection protrusions 102. In an alternative embodiment, the detection system comprises at least one detection protrusion, and the detection system is adapted to detect the fault situation based on deformation of the at least one detection protrusion, such as bending or braking of the at least one detection protrusion.

Said bending of the detection protrusions 102 triggers the release of the fire prevention substance from the fire prevention system 10, and creates a flow aperture adjacent each detection protrusion 102. Each flow aperture is located between a bent detection protrusions 102 and the pressure relief device 8, and is adapted to provide a path for the fire prevention substance out of the fire prevention system 10.

The release of the fire prevention substance from the fire prevention system 10 is triggered by the bending of the detection protrusions 102 since a wall of a container containing the fire prevention substance is fractured by the deformation of the detection protrusions 102. In an alternative embodiment, a deformation of the at least one detection protrusion releases the fire prevention substance by pulling a pin from a container containing the fire prevention substance.

In a further alternative embodiment, the detection system comprises a mechanical connection between the pressure relief device and the fire prevention system such that the transition of the pressure relief device from the first operating position to the second operating position releases fire prevention substance from the fire prevention system. The mechanical connection between the pressure relief device and the fire prevention system comprises a cable and/or linkage.

In a yet further alternative embodiment, the detection system comprises at least one sensor adapted to detect the at least one indicative event, the at least one sensor comprising at least one of the following: pressure sensor, temperature sensor, photosensor, strain gauge. The pressure sensor is adapted to detect a second predetermined pressure rise inside the housing, wherein the at least one indicative event comprises the second predetermined pressure rise. The temperature sensor is adapted to detect a predetermined temperature rise inside the housing, wherein the at least one indicative event comprises the predetermined temperature rise. The photosensor is adapted to detect a predetermined illuminance rise inside the housing, wherein the at least one indicative event comprises the predetermined illuminance rise. The predetermined illuminance rise is selected such that the photosensor is adapted to detect an electric arc inside the housing but to ignore all normally occurring changes in illumination inside the housing. The strain gauge is adapted to detect a predetermined deformation in the support structure, for example in the plate spring, wherein the at least one indicative event comprises the predetermined deformation.

In an embodiment where the at least one indicative event comprises a second predetermined pressure rise, the second predetermined pressure rise is less than the first predetermined pressure rise. Consequently, the fire prevention system starts to release the fire prevention substance inside the housing before the pressure relief device has opened, thereby ensuring that the moment the pressure relief device opens, the fire prevention substance flows out of the housing, and decreases fire risk at the vicinity of the fluid port.

In embodiments where the detection system comprises at least one sensor, the electric apparatus comprises a control system which is communicatively connected to the at least one sensor, and is adapted to trigger the release of the fire prevention substance from the fire prevention system as a response to the at least one indicative event detected by the at least one sensor.

It will be obvious to a person skilled in the art that the inventive concept can be implemented in various ways. The invention and its embodiments are not limited to the examples described above but may vary within the scope of the claims.

## Claims

1. An electric apparatus comprising:
a housing (2);
an electric equipment (4) located inside the housing (2);
a fluid port (6) providing a fluid connection from inside of the housing (2) to outside of the housing (2);
a pressure relief device (8) having a first operating position adapted to prevent fluid flow through the fluid port (6), and a second operating position adapted to allow fluid flow through the fluid port (6), wherein a transition of the pressure relief device (8) from the first operating position to the second operating position is adapted to take place as a response to a first predetermined pressure rise inside the housing (2), and
a detection system adapted to detect a fault situation relating to the electric equipment (4) based on at least one indicative event, and
a fire prevention system (10) comprising fire prevention substance, and being operatively connected to the detection system such that the fire prevention system (10) is adapted to release the fire prevention substance as a response to the fault situation detected by the detection system,
**characterized in that** the at least one indicative event comprises the transition of the pressure relief device (8) from the first operating position to the second operating position,
wherein the pressure relief device (8) defines a pressure relief device plane, and the fluid port (6) is provided on a planar section of the housing (2) defining a first housing plane, wherein during the transition of the pressure relief device (8) from the first operating position to the second operating position, the pressure relief device plane remains parallel to the first housing plane, and
wherein the housing (2) contains air such that the electric equipment (4) is at least partially surrounded by the air.

2. An electric apparatus according to claim 1, **characterized in that** the detection system comprises at least one sensor adapted to detect the at least one indicative event.

3. An electric apparatus according to claim 2, **characterized in that** the at least one sensor comprises at least one of the following: a pressure sensor adapted to detect a second predetermined pressure rise inside the housing (2), wherein the at least one indicative event comprises the second predetermined pressure rise; a temperature sensor adapted to detect a predetermined temperature rise inside the housing (2), wherein the at least one indicative event comprises the predetermined temperature rise; a photosensor adapted to detect a predetermined illuminance rise inside the housing (2), wherein the at least one indicative event comprises the predetermined illuminance rise.

4. An electric apparatus according to claim 2 or 3, **characterized in that** the pressure relief device (8) is supported to the housing (2) by a support structure (12), and the at least one sensor comprises a strain gauge adapted to detect a predetermined deformation in the support structure (12), wherein the at least one indicative event comprises the predetermined deformation.

5. An electric apparatus according to any one of the preceding claims, **characterized in that** the fault situation which the detection system is adapted to detect comprises an electric arc inside the housing (2).

6. An electric apparatus according to any one of the preceding claims, **characterized in that** the fire prevention system (10) comprises a disposable cartridge containing the fire prevention substance.

7. An electric apparatus according to any one of the preceding claims, **characterized in that** the fire prevention substance comprises at least one of the following: substance adapted to displace oxygen, substance adapted to lower temperature, substance adapted to trap explosive gases.

8. An electric apparatus according to any one of the preceding claims, **characterized in that** the electric equipment (4) comprises an electric converter adapted to convert electric energy from one form to another.

9. An electric apparatus according to any one of the preceding claims, **characterized in that** the fire prevention system (10) is adapted to release the fire prevention substance inside the housing (2) as a response to the fault situation detected by the detection system.

10. An electric apparatus according to any one of the preceding claims, **characterized in that** the detection system comprises a mechanical connection between the pressure relief device (8) and the fire prevention system (10) such that the transition of the pressure relief device (8) from the first operating position to the second operating position releases fire prevention substance from the fire prevention system (10).

11. An electric apparatus according to claim 10, **characterized in that** the mechanical connection between the pressure relief device (8) and the fire prevention system (10) comprises a cable and/or linkage.

## Patentansprüche

1. Elektrische Vorrichtung, umfassend:
ein Gehäuse (2);
eine elektrische Ausrüstung (4), die sich im Gehäuse (2) befindet;
einen Fluidanschluss (6), der eine Fluidverbindung von der Innenseite des Gehäuses (2) zur Außenseite des Gehäuses (2) bereitstellt;
eine Druckentlastungseinrichtung (8) mit einer ersten Betriebsstellung, die dazu ausgelegt ist, einen Fluidstrom durch den Fluidanschluss (6) zu verhindern, und einer zweiten Betriebsstellung, die dazu ausgelegt ist, einen Fluidstrom durch den Fluidanschluss (6) zu ermöglichen, wobei ein Übergang der Druckentlastungseinrichtung (8) von der ersten Betriebsstellung zur zweiten Betriebsstellung dazu ausgelegt ist, als Reaktion auf einen ersten vorbestimmten Druckanstieg innerhalb des Gehäuses (2) zu erfolgen, und
ein Detektionssystem, das dazu ausgelegt ist, eine Fehlersituation in Bezug auf die elektrische Ausrüstung (4) basierend auf mindestens einem Anzeigeereignis zu detektieren, und
ein Brandschutzsystem (10), das Brandschutzsubstanz umfasst und mit dem Detektionssystem wirkverbunden ist, so dass das Brandschutzsystem (10) dazu ausgelegt ist, die Brandschutzsubstanz als Reaktion auf die durch das Detektionssystem detektierte Fehlersituation freizusetzen,
**dadurch gekennzeichnet, dass** das mindestens eine Anzeigeereignis den Übergang der Druckentlastungseinrichtung (8) von der ersten Betriebsstellung zur zweiten Betriebsstellung umfasst,
wobei die Druckentlastungseinrichtung (8) eine Druckentlastungseinrichtungsebene definiert und der Fluidanschluss (6) an einem planaren Abschnitt des Gehäuses (2) bereitgestellt ist, der eine erste Gehäuseebene definiert, wobei während des Übergangs der Druckentlastungseinrichtung (8) von der ersten Betriebsstellung in die zweite Betriebsstellung die Druckentlastungseinrichtungsebene parallel zur ersten Gehäuseebene bleibt, und
wobei das Gehäuse (2) Luft enthält, so dass die elektrische Ausrüstung (4) zumindest teilweise von der Luft umgeben ist.

2. Elektrische Vorrichtung nach Anspruch 1, **dadurch gekennzeichnet, dass** das Detektionssystem mindestens einen Sensor umfasst, der dazu ausgelegt ist, das mindestens eine Anzeigeereignis zu detektieren.

3. Elektrische Vorrichtung nach Anspruch 2, **dadurch gekennzeichnet, dass** der mindestens eine Sensor mindestens einen der folgenden umfasst: einen Drucksensor, der dazu ausgelegt ist, einen zweiten vorbestimmten Druckanstieg innerhalb des Gehäuses (2) zu detektieren, wobei das mindestens eine Anzeigeereignis den zweiten vorbestimmten Druckanstieg umfasst; einen Temperatursensor, der dazu ausgelegt ist, einen vorbestimmten Temperaturanstieg innerhalb des Gehäuses (2) zu detektieren, wobei das mindestens eine Anzeigeereignis den vorbestimmten Temperaturanstieg umfasst; einen Fotosensor, der dazu ausgelegt ist, einen vorbestimmten Beleuchtungsstärkenanstieg innerhalb des Gehäuses (2) zu detektieren, wobei das mindestens eine Anzeigeereignis den vorbestimmten Beleuchtungsstärkenanstieg umfasst.

4. Elektrische Vorrichtung nach Anspruch 2 oder 3, **dadurch gekennzeichnet, dass** die Druckentlastungseinrichtung (8) durch eine Stützstruktur (12) am Gehäuse (2) abgestützt ist und der mindestens eine Sensor einen Dehnungsmessstreifen umfasst, der dazu ausgelegt ist, eine vorbestimmte Verformung in der Stützstruktur (12) zu detektieren, wobei das mindestens eine Anzeigeereignis die vorbestimmte Verformung umfasst.

5. Elektrische Vorrichtung nach einem der vorhergehenden Ansprüche, **dadurch gekennzeichnet, dass** die Fehlersituation, zu der das Detektionssystem eingerichtet ist, einen Lichtbogen innerhalb des Gehäuses (2) umfasst.

6. Elektrische Vorrichtung nach einem der vorhergehenden Ansprüche, **dadurch gekennzeichnet, dass** das Brandschutzsystem (10) eine Einwegkartusche umfasst, die die Brandschutzsubstanz enthält.

7. Elektrische Vorrichtung nach einem der vorhergehenden Ansprüche, **dadurch gekennzeichnet, dass** die Brandschutzsubstanz mindestens eine der folgenden umfasst: Substanz, die zum Verdrängen von Sauerstoff angepasst ist, Substanz, die an niedrigere Temperatur angepasst ist, Substanz, die zum Einfangen von explosionsfähigen Gasen angepasst ist.

8. Elektrische Vorrichtung nach einem der vorhergehenden Ansprüche, **dadurch gekennzeichnet, dass** die elektrische Ausrüstung (4) einen elektrischen Wandler umfasst, der dazu ausgelegt ist, elektrische Energie von einer Form in eine andere umzuwandeln.

9. Elektrische Vorrichtung nach einem der vorhergehenden Ansprüche, **dadurch gekennzeichnet, dass** das Brandschutzsystem (10) dazu eingerichtet ist, die Brandschutzsubstanz innerhalb des Gehäuses (2) als Reaktion auf die von dem Detektionssystem detektierte Fehlersituation freizusetzen.

10. Elektrische Vorrichtung nach einem der vorhergehenden Ansprüche, **dadurch gekennzeichnet, dass** das Detektionssystem eine mechanische Verbindung zwischen der Druckentlastungseinrichtung (8) und dem Brandschutzsystem (10) umfasst, so dass der Übergang der Druckentlastungseinrichtung (8) von der ersten Betriebsstellung in die zweite Betriebsstellung Brandschutzsubstanz aus dem Brandschutzsystem (10) freisetzt.

11. Elektrische Vorrichtung nach Anspruch 10, **dadurch gekennzeichnet, dass** die mechanische Verbindung zwischen der Druckentlastungseinrichtung (8) und dem Brandschutzsystem (10) ein Kabel und/oder Gestänge umfasst.

## Revendications

1. Appareil électrique comprenant :
un boîtier (2) ;
un équipement électrique (4) situé à l'intérieur du boîtier (2) ;
un orifice de fluide (6) assurant une liaison fluidique de l'intérieur du boîtier (2) à l'extérieur du boîtier (2) ;
un dispositif de décharge de pression (8) présentant une première position de fonctionnement conçue pour empêcher l'écoulement de fluide à travers l'orifice de fluide (6), et une deuxième position de fonctionnement conçue pour permettre l'écoulement de fluide à travers l'orifice de fluide (6), un passage du dispositif de décharge de pression (8) de la première position de fonctionnement à la deuxième position de fonctionnement étant conçu pour se produire en réponse à une première augmentation de pression prédéterminée à l'intérieur du boîtier (2), et un système de détection conçu pour détecter une situation de défaut concernant l'équipement électrique (4) sur la base d'au moins un événement indicatif, et
un système de prévention d'incendie (10) comprenant une substance de prévention d'incendie, et étant relié fonctionnellement au système de détection de sorte que le système de prévention d'incendie (10) est conçu pour libérer la substance de prévention d'incendie en réponse à la situation de défaut détectée par le système de détection,
**caractérisé en ce que** l'au moins un événement indicatif comprend le passage du dispositif de décharge de pression (8) de la première position de fonctionnement à la deuxième position de fonctionnement,
dans lequel le dispositif de décharge de pression (8) définit un plan de dispositif de décharge de pression, et l'orifice de fluide (6) est ménagé sur une section plane du boîtier (2) définissant un premier plan de boîtier, le plan de dispositif de décharge de pression restant parallèle au premier plan de boîtier pendant le passage du dispositif de décharge de pression (8) de la première position de fonctionnement à la deuxième position de fonctionnement, et
dans lequel le boîtier (2) contient de l'air de sorte que l'équipement électrique (4) est au moins partiellement entouré par l'air.

2. Appareil électrique selon la revendication 1, **caractérisé en ce que** le système de détection comprend au moins un capteur conçu pour détecter l'au moins un événement indicatif.

3. Appareil électrique selon la revendication 2, **caractérisé en ce que** l'au moins un capteur comprend au moins l'un des capteurs suivants : un capteur de pression conçu pour détecter une deuxième augmentation de pression prédéterminée à l'intérieur du boîtier (2), l'au moins un événement indicatif comprenant la deuxième augmentation de pression prédéterminée ; un capteur de température conçu pour détecter une augmentation de température prédéterminée à l'intérieur du boîtier (2), l'au moins un événement indicatif comprenant l'augmentation de température prédéterminée ; un capteur photosensible conçu pour détecter une augmentation d'éclairement prédéterminée à l'intérieur du boîtier (2), l'au moins un événement indicatif comprenant l'augmentation d'éclairement prédéterminée.

4. Appareil électrique selon la revendication 2 ou 3, **caractérisé en ce que** le dispositif de décharge de pression (8) est supporté par le boîtier (2) au moyen d'une structure de support (12), et l'au moins un capteur comprend une jauge de contrainte conçue pour détecter une déformation prédéterminée dans la structure de support (12), l'au moins un événement indicatif comprenant la déformation prédéterminée.

5. Appareil électrique selon l'une quelconque des revendications précédentes, **caractérisé en ce que** la situation de défaut que le système de détection est conçu pour détecter comprend un arc électrique à l'intérieur du boîtier (2).

6. Appareil électrique selon l'une quelconque des revendications précédentes, **caractérisé en ce que** le système de prévention d'incendie (10) comprend une cartouche jetable contenant la substance de prévention d'incendie.

7. Appareil électrique selon l'une quelconque des revendications précédentes, **caractérisé en ce que** la substance de prévention d'incendie comprend au moins l'une des substances suivantes : une substance conçue pour déplacer l'oxygène, une substance conçue pour abaisser la température, une substance conçue pour piéger les gaz explosifs.

8. Appareil électrique selon l'une quelconque des revendications précédentes, **caractérisé en ce que** l'équipement électrique (4) comprend un convertisseur électrique conçu pour convertir de l'énergie électrique d'une forme à une autre.

9. Appareil électrique selon l'une quelconque des revendications précédentes, **caractérisé en ce que** le système de prévention d'incendie (10) est conçu pour libérer la substance de prévention d'incendie à l'intérieur du boîtier (2) en réponse à la situation de défaut détectée par le système de détection.

10. Appareil électrique selon l'une quelconque des revendications précédentes, **caractérisé en ce que** le système de détection comprend une liaison mécanique entre le dispositif de décharge de pression (8) et le système de prévention d'incendie (10) de sorte que le passage du dispositif de décharge de pression (8) de la première position de fonctionnement à la deuxième position de fonctionnement libère une substance de prévention d'incendie à partir du système de prévention d'incendie (10).

11. Appareil électrique selon la revendication 10, **caractérisé en ce que** la liaison mécanique entre le dispositif de décharge de pression (8) et le système de prévention d'incendie (10) comprend un câble et/ou une tringlerie.
